(19) Europäisches Patentamt / European Patent Office / Office européen des brevets

(11) **EP 2 159 307 A1**

(12) **EUROPEAN PATENT APPLICATION**
published in accordance with Art. 153(4) EPC

(43) Date of publication:
**03.03.2010 Bulletin 2010/09**

(21) Application number: **08753079.6**

(22) Date of filing: **15.05.2008**

(51) Int Cl.:
*D01F 8/14* (2006.01)   *B41N 1/24* (2006.01)
*D01F 6/62* (2006.01)   *D03D 1/00* (2006.01)
*D03D 9/00* (2006.01)   *D03D 15/00* (2006.01)
*D03D 15/02* (2006.01)

(86) International application number:
**PCT/JP2008/059407**

(87) International publication number:
**WO 2008/146690 (04.12.2008 Gazette 2008/49)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **24.05.2007   JP 2007137674**

(71) Applicant: **Teijin Fibers Limited
Osaka-shi, Osaka 541-0054 (JP)**

(72) Inventor: **OKA, Yuki
Matsuyama-shi
Ehime 791-8041 (JP)**

(74) Representative: **Hallybone, Huw George et al
Carpmaels & Ransford
43-45 Bloomsbury Square
London WC1A 2RA (GB)**

(54) **MONOFILAMENT FOR SCREEN FABRIC AND PROCESS FOR PRODUCTION OF SCREEN FABRIC**

(57)   A fabric formed of a monofilament for screen mesh cloth of such that, after wet heat treatment, the inclination change B/A thereof is from 0.6 to less than 1.0 (in which A indicates the inclination of the elongation-stress curve just before the primary yield point thereof and B indicates the inclination of the elongation-stress curve just after the primary yield point), is processed with boiling water and then heat-set while stretched by from 0.2 to 5 % both in the warp direction and in the weft direction, and thereafter further stretched by from 0.3 to 5 % and fixed, thereby giving a high-mesh and high-modulus screen mesh cloth excellent in the weaving process stability and in the stability and the continuous printability as screen mesh cloth.

**Description**

TECHNICAL FIELD

The present invention relates to a monofilament for screen mesh cloth capable of giving a screen mesh cloth of high-level accuracy not requiring great extension in screen tensioning by removing the remarkable elongation stress change before and after the primary yield point.

BACKGROUND ART

Monofilaments are widely utilized not only in the field of clothes but also in the field of industrial materials. For example, examples of their applications in the field of industrial materials include tire cords, ropes, nets, silken guts, tarpaulins, tents, paragliders, and sail cloths, and in addition, monofilaments for screen mesh cloths.

In particular, as monofilaments for screen mesh cloths, heretofore much used are polyester monofilaments because of their stability to heat and moisture and their economical reasons (for example, JP-A 2-289120).

However, with the recent tendency toward large scale integration in printing in the field of electronic circuits, the demand for printing densification and printability enhancement for screen mesh cloths for printing is increasing more and more; and in such situation, polyester monofilaments have a region in which the stress does not so much change even though they are stretched to a degree of elongation of from 8 to 10 % or so (primary yield point), as undergoing boiling water treatment such as dyeing, and this is a bar to the production and use of screen mesh cloths.

Specifically, a screen mesh cloth is used all the time while stretched and contracted by the blade for spreading a printing paste, but when the monofilaments constituting the screen mesh cloth are stretched at around the primary yield point thereof, then the cloth could not be contracted even after the blade has left from it, therefore resulting in a problem of pattern shifting; and for solving it, the polyester monofilaments must be stretched by about 14 % in the stage of working them into a screen mesh cloth, and this lowers the working efficiency.

In addition, when monofilaments are stretched greatly and when there occurs a trouble of sliding or bias or bowed filling in such their stretching, then it is problematic in that they could not be used in precision printing. Accordingly, it is desired to develop a polyester core/ sheath monofilament usable for screen mesh cloth even though not stretched by 14 %.

DISCLOSURE OF THE INVENTION

An object of the invention is to provide a polyester monofilament favorable for mesh cloths for use in screen printing, and precisely to provide a monofilament for screen mesh cloth which does not require great extension in screen tensioning, which has excellent workability and which may give a screen mesh cloth of high-level accuracy.

The present inventors have assiduously studied for the purpose of attaining the above-mentioned object and, as a result, have found that, when the inclination of the elongation-stress curve before and after the primary yield point of a monofilament after processed with boiling water is controlled to fall within a specific range, then the object of the invention can be attained.

Specifically, according to the invention, there are provided the following:

(1) A polyester monofilament for screen mesh cloth **characterized in that**, after processed with boiling water, its inclination change B/A is from 0.6 to less than 1.0, wherein A indicates the inclination of the elongation-stress curve just before the primary yield point thereof and B indicates the inclination of the elongation-stress curve just after the primary yield point, and

(2) A method for producing a screen mesh cloth, characterized by comprising processing a fabric formed of the monofilament for screen mesh cloth with boiling water and then stretching it by from 0.5 to 10 % and fixing it.

BEST MODE FOR CARRYING OUT THE INVENTION

Embodiments of the invention are described in detail hereinunder.

In general, fine monofilaments having a fineness of at most 24 dtex are used for high-mesh screens (200 to 500 meshes) suitable to precision printing. These fine monofilaments must have physical properties of strength and elongation enough to prevent the reduction in weavability thereof and the elongation of screen mesh cloths in printing (reduction in dimensional stability).

The performance is generally evaluated by the stress of the raw yarn at an elongation of 5 % (modulus, hereinafter this may be referred to as 5 % LASE); however, for the purpose of attaining further high-level dimensional stability, the inventors have found that it is important to consider not only 5 % LASE but also the influence on the raw yarn of the wet heat treatment in a process of producing screen mesh cloths (the wet heat treatment generally means that a woven screen mesh cloth is processed with hot water or steam in a process of scouring or dying it).

The present invention has been made on the basis of these findings, and the monofilament for screen mesh cloth of the invention is as follows: The monofilament is, as a hank thereof, processed under wet heat in a wet heat atmosphere under high pressure at 130°C for 10 minutes, according to the method of measurement of wet heat shrinkage to be mentioned hereinunder, and after the treatment, its inclination change B/A must be from 0.6 to less than 1.0 wherein A indicates the inclination of the elongation-stress curve just before the primary yield point thereof and B indicates the inclination of the elongation-stress curve just after the primary yield point.

A preferred embodiment of the monofilament for screen mesh cloth of the invention is a core/sheath bicomponent polyester monofilament having a monofilament fineness of from 4 to 24 dtex in which the core component is a high-IV polyethylene naphthalate and the sheath component is a low-IV polyester; and the maximum point strength of the monofilament before wet heat treatment is from 5.5 to 8.0 cN/dtex, the strength at 5 % elongation is from 3.8 to 5.5 cN/dtex, the maximum point elongation is from 8 to 20 %, the wet heat shrinkage is from 0.5 to 3.5 %, the maximum point strength after wet heat treatment is from 5.0 to 7.8 cN/dtex, and the maximum point elongation is from 15 to 30 %. The screen mesh cloth formed of the monofilament of this embodiment may have excellent and high-level dimensional stability, after processed for weaving texture arrangement or wet heat fixation or screen tensioning. The maximum point strength and the elongation means the strength and the elongation at break of the raw yarn in the load-elongation curve thereof.

The core/sheath monofilament for screen mesh cloth of the invention is a core/sheath monofilament produced by the use of an ordinary bicomponent spinning device, in which from 0.5 to 0.8 dL/gofa high-IV polyethylene naphthalate is used for the core and from 0.40 to 0.65 dL/g of a polyester is for the sheath. The cross section perpendicular to the fiber axis is preferably a circular cross section. In the cross section, the core and the sheath are not required to be the similar figure; but the core must be fully covered with the sheath. A preferred core/sheath area ratio is from 30/70 to 90/10.

When IV of the polyethylene naphthalate of the core is from 0.5 to 0.8, then the yarn may have a high elongation and a high modulus; and when IV of the polyester of the sheath is from 0.40 to 0.65, then the yarn may be soft and therefore the reed may be prevented from being abraded by the yarn during weaving.

The polyester for the sheath is preferably polyethylene terephthalate having IV of from 0.40 to 0.65. When IV is less than 0.40, the yarn strength may be low; and when more than 0.65, it is unfavorable since the reed abrasion may be great.

The birefringence of the polyester for sheath must be from $110 \times 10^{-3}$ to $170 \times 10^{-3}$. When the birefringence is less than $110 \times 10^{-3}$, then the raw yarn before and after boiling water treatment could hardly have the intended strength; but on the other hand, when the birefringence is more than $170 \times 10^{-3}$, it is unfavorable since abrasion dust may adhere to the reed during weaving and the weavability may worsen.

The core/sheath monofilament of the invention must be so planned that its maximum point strength before wet heat treatment is from 5.5 to 8.0 cN/dtex, its 5% LASE is from 3.8 to 5.5 cN/dtex, its maximum point elongation is from 8 to 20 %, and its wet heat shrinkage is from 0.5 to 3.5 %.

When the maximum point strength is less than 5.5 cN/dtex, then the screen mesh cloth strength may be low and the cloth may be broken during screen tensioning; but when more than 8.0 cN/dtex, then the cloth could hardly have the intended shrinkage and the reed may be abraded during weaving. When the maximum point elongation is less than 8 %, then the yarn may be often cut during weaving and the yarn handlability may be poor. When the maximum point elongation is more than 20 %, then the mesh cloth may be readily elongated.

The 5 % LASE is preferably higher, but when it is more than 5.5 cN/dtex, then it is unfavorable since the reed may be abraded during weaving, and the abrasion dust may be woven into the fabric to form defects. On the contrary, when it is less than 3.8 cN/dtex, then it is unfavorable since the screen mesh cloth elongation may be great.

The wet heat shrinkage of the core/sheath monofilament of the invention is preferably within a range of from 0.5 to 3.5 %.

A concrete method for producing the core/sheath monofilament having the characteristics as above is described below, to which, however, the invention should not be limited.

The above-mentioned polyethylene terephthalate and low-IV polyester are melt-spun into a core/sheath monofilament, using a bicomponent spinneret according to an ordinary method, and then stretched. In the spinning step, the unstretched monofilament may be once wound up, and then this may be separately subjected to the stretching step; however, preferably, the stretching is attained directly after the spinning step.

In the direct spinning and stretching mode, it is desirable that a few pairs of hot rolls are sued and the yarn is stretched in one stage or multiple stages; and the draw ratio in stretching is so defined that the strength, the elongation and the shrinkage of the stretched yarn each could be finally within a predetermined range. The stretching may include relaxation treatment such as relaxation stretching, by which the wet heat shrinkage of the stretched yarn could be so controlled as to fall within a predetermined range.

In the manner as above, the physical properties of the raw yarn are controlled before weaving, and then, the yarn is subjected to a weaving step, and if desired, it may be shrunk through wet heat treatment such as scoring or dyeing, whereby the yarn may have predetermined strength and elongation characteristics after the wet heat shrinking treatment, and the screen mesh cloth formed of it may have high-level dimensional stability.

Knobs to form in the surface of the monofilament are unfavorable as causing yarn cutting or scum generation during weaving, and therefore they must be prevented as much as possible. The reasons of formation of knobs may be the unmelted impurities in the polymer or the degradation of the polymer itself. Regarding the unmelted impurities in the polymer, they may be prevented from being ejected out or may be dispersed by forming a filter layer in the course from the pack inlet to the spinneret jet-out mouth. Regarding the filter layer, its pore size is preferably from about 10 to 15 % of the diameter of the monofilament. When the pore size is less than 10 %, then some abnormal pressure may be given to the inside area of the pack with the result that the members inside the pack and the pack body may be broken. When the pore size is more than 15 %, then the unmelted impurities that are the reasons of the knobbed yarn may still exist in the yarn as coarse particles therein, and the risk of knob formation may be large. Regarding the degradation of the polymer itself, the polymer feeding line may be modified. For example, the duct bending may be reduced and the time to be taken from the introduction into the pack to the ejection from it is to be within 1 minute, and the amount of heat that the polymer receives may be reduced as much as possible, whereby the risk of knob formation may be reduced.

In the invention, the fabric formed of the monofilament produced according to the above-mentioned method is processed in boiling water and then heat-set while kept stretched by from 0.2 to 5 % in both the weft direction and the warp direction. This is fixed in a screen frame while stretched by from 0.3 to 5 %, and in that condition, this is used as a screen mesh cloth. Even after the blade used for spreading a printing paste on it is left away, the screen mesh cloth does not shrink and hardly has a trouble of sliding or bias or bowed filling, and therefore it is free from a problem of pattern shifting even in precision printing.

In this case, the texture and the density of the fabric to be used as the screen mesh cloth may be any known ones. For example, a Sulzer weaving machine is used, and a plain woven fabric is preferably produced, having a warp density of from 200 to 400/inch and a weft density of from 200 to 400/inch.

Preferably, a stretching roll, a tenter or the like is used for the treatment of stretching and heat setting after the hot water treatment; and also preferably, the fabric may be stretched by from 0.2 to 5 % in both the warp direction and the weft direction, and then processed for dry heat treatment at from 160˚C to 210˚C. Preferably, the fixation may be attained by the use of a screen tensioner, by which the fabric may be stretched preferably by from 0.3 to 5 % in the warp direction and by from 0.3 to 5 % in the weft direction.

EXAMPLES

The invention is described more concretely with reference to the following Examples and Comparative Examples. The data shown in Examples are determined according to the following methods.

(1) Intrinsic Viscosity:

Diluted solutions each having a different concentration (C) are prepared by dissolving a sample in orthochlorophenol at 35˚C. From the viscosity ($\eta r$) of each solution, C is approximated to 0 according to the following expression, thereby computing the intrinsic viscosity of the sample.

$$\eta = \text{limit } (\ln(\eta r/C))$$

The components of the core and the sheath are analyzed for the data as follows: A spinneret is so planned that the residence time through it in melting could be the same as that through the spinneret for use in spinning but that the two polymers for the core and the sheath could be separately spun out, and through the spinneret, the polymer flow condition is fully stabilized and the running polymer flow is sampled and tested.

(2) Strength, Elongation:

The strength and the elongation of the fiber are determined according to JIS-L1017, using an Orientec's Tensilon. The sample length is 25 cm, the elongation speed is 30 cm/min. The strength and the elongation at break of the sample are measured.

(3) Stress at 5 % elongation (5 % LASE):

The stress of the sample used for measurement of the strength and the elongation thereof is measured, at its 5 % elongation.

(4) Wet Heat Shrinkage:

5000 m of a monofilament is sampled and formed into a hank, then this is processed under wet heat for 10 minutes in a wet heat atmosphere at 130˚C under high pressure with applying a load of [fineness $\times$ 0.1 times (g)] thereto. After the treatment, the yarn is spontaneously dried, and the length of the yarn is again measured. The length of the yarn after the treatment is divided by the length of the yarn before the treatment, 5000 m, and the value is expressed as percentage to be the wet heat shrinkage.

(5) Number of Knobs:

Before the dropper disposed at the creel port of a warping machine, a 12-pass slit guide is disposed, each having a clearance of fiber diameter $\times$ 1.1 times with a tolerance $\pm$ 2$\mu$ m. Yarns are led to pass through the slit guide, and 12 yarns $\times$ 8 stages = 96 yarns are warped at a yarn speed of 500 m/min to a yarn length of 200,000 m. In this step, the frequency of yarn cutting through the slit guide is considered as the number of the knobs, and the yarn cutting frequency during the warping operation is counted. The number of the thus-detected yarn cutting frequency is converted into the number of knobs per 100,000 m of the yarn.

(7) Test of Yarn Abrasion:

Using a Sulzer weaving machine, a mesh fabric is woven. The number of rotation of the weaving machine is 250 rpm, and 300 yarns for the warp are woven to give a woven fabric having a width of 1 inch. The woven fabric is visually inspected with a fabric inspector. In this, the number of whitish defects, which should look black, in the woven fabric is counted in a size of 1.5 m width $\times$ 300 m length, and the fabric is evaluated according to the following criteria:

○: Less than 5 defects by yarn abrasion.
△: From 5 to less than 10 defects.
✕: 10 or more defects.

(8) Hysteresis Evaluation (characteristic substitutive for dimensional stability of screen mesh cloth):

A load at 7 % elongation is applied as an initial load to a raw yarn after wet heat treatment, and from it, further 1.5 % continuous elongation is applied 1000 times under a load (B). A ratio, C, of the load (B) to a load (A) at the 30th elongation, C = B/A $\times$ 100 indicates the hysteresis of the sample.
It may be said that samples having C of at least 98 % may have sufficient dimensional stability.

(9) Density Unevenness of Screen Mesh Cloth:

Using a densitometer, the density of a sample in the warp direction and the weft direction is read, and the difference from the planned density is computed.

(Example 1)

Polyethylene naphthalate having an intrinsic viscosity of 0.68 dL/g was used as the core, and polyethylene terephthalate having an intrinsic viscosity of 0.63 dL/g was as the sheath. Both were melted at a temperature of 300˚C. 2 hours after the start of the polymer flowing, the sample taken from the core had an intrinsic viscosity of 0.61 dL/g, and the sample taken from the sheath had an intrinsic viscosity of 0.54 dL/g.
The core/sheath bicomponent polyester monofilament formed of the above polymers was, while wound up at a spinning speed of 700 m/min, oiled with an oily agent using an oiling roller, thereby giving an unstretched yarn. Next, this was preheated with a heated hot roller, and then, while heated with a slit heater at 230˚C, stretched by 5.0 times and then relaxed by 0.05 times, and thereafter wound up to give a stretched yarn of 13 dtex-lfil.
The obtained stretched yarn had a strength of 6.1 cN/dtex, an elongation of 15 %, a 5 % LASE of 4.4 cN/dtex, a wet heat shrinkage of 2.7 %; and after wet heat treatment, it had a strength of 6.0 cN/dtex, an elongation of 20 %, a 15 % LASE of 5.4 cN/dtex. The inclination change B/A before and after the primary yield point of the yarn after wet heat treatment was 0.8.
The monofilaments were woven into a plain fabric having a warp density of 300/inch and a weft density of 300/inch. The number of the knobbed yarn was 1, and there was no yarn abrasion, or that is, the yarn had good weavability. The plain fabric was processed with boiling water, and then using a stretching roll, this was stretched by 3 % in the warp direction, and thereafter while the drat ratio in stretching in the warp direction was kept as such, this was stretched with a tenter by 3 % in the weft direction, and thereafter this was heat-set at 170˚C. Next, using a screen tensioner, this was stretched by 4 % in the warp direction and by 4 % in the weft direction, and then fixed. As a result, a uniform screen mesh cloth was obtained, of which the density unevenness in the warp direction and the weft direction was less than 3 %. The screen mesh cloth was evaluated for the hysteresis, and its C value was 99 % and its dimensional stability was thus good.

(Comparative Example 1)

Polyethylene terephthalate having an intrinsic viscosity of 0.85 dL/g was used as the core, and polyethylene terephthalate having an intrinsic viscosity of 0.63 dL/g was as the sheath. Both were melted at a temperature of 295˚C. 2 hours after the start of the polymer flowing, the sample taken from the core had an intrinsic viscosity of 0.74 dL/g, and the sample taken from the sheath had an intrinsic viscosity of 0.52 dL/g.
The core/sheath bicomponent polyester monofilament formed of the above polymers was, while wound up at a spinning speed of 700 m/min, oiled with an oily agent using an oiling roller, thereby giving an unstretched yarn. Next, this was preheated with a hot roller heated at 150˚C, and then, while heated with a slit heater at 200˚C, stretched by 4.2 times and then relaxed by 0.05 times, and thereafter wound up to give a stretched yarn of 13 dtex-lfil.
The obtained stretched yarn had a strength of 6.1 cN/dtex, an elongation of 25 %, a 5 % LASE of 4.0 cN/dtex, a wet heat shrinkage of 8.0 %; and after wet heat treatment, it had a strength of 6.0 cN/dtex. The inclination change B/A before and after the primary yield point of the yarn after wet heat treatment was 0.2.
The monofilaments were woven into a plain fabric having a warp density of 300/inch and a weft density of 300/inch. The number of the knobbed yarn was 1, and there was no yarn abrasion, or that is, the yarn had good weavability. The plain fabric was processed with boiling water, and then using a stretching roll, this was stretched by 3 % in the warp direction, and thereafter while the drat ratio in stretching in the warp direction was kept as such, this was stretched with a tenter by 3 % in the weft direction, and thereafter this was heat-set at 170˚C. Next, using a screen tensioner, this was stretched by 4 % in the warp direction and by 4 % in the weft direction, and then fixed. As a result, this was an ununiform screen mesh, of which the density unevenness in the warp direction and the weft direction was 8 %. The screen mesh cloth was evaluated for the hysteresis, and its C value was 92 % and its dimensional stability was thus insufficient.

In order to produce a uniform screen mesh cloth having a density unevenness of less than 3 % from this plain fabric, the fabric must be stretched by at least 7 % in the stretching and heat-setting step and by at least 7 % in the screen-tensioning step, or that is, by at least 14 % as a whole; and if not, a uniform screen mesh cloth could not be obtained. The C value in the case was 99 %.

(Example 2)

A stretched yarn was obtained according to the same process as in Example 1, for which, however, the slit heater temperature in stretching was changed to 240˚C. The obtained stretched yarn had a strength of 6.1 cN/dtex, an elongation of 16 %, a 5 % LASE of 4.3 cN/dtex, a wet heat shrinkage of 2.3 %; and after wet heat treatment, it had a strength of 6.1 cN/dtex, an elongation of 20 %. The inclination change B/A before and after the primary yield point of the yarn after wet heat treatment was 0.75.

The monofilaments were woven into a plain fabric having a warp density of 300/inch and a weft density of 300/inch. The number of the knobbed yarn was 1, and there was no yarn abrasion, or that is, the yarn had good weavability. The plain fabric was processed with boiling water, and then using a stretching roll, this was stretched by 3 % in the warp direction, and thereafter while the drat ratio in stretching in the warp direction was kept as such, this was stretched with a tenter by 3 % in the weft direction, and thereafter this was heat-set at 170˚C. Next, using a screen tensioner, this was stretched by 4 % in the warp direction and by 4 % in the weft direction, and then fixed (that is, stretched by 7 % as a whole in the warp direction and the weft direction). As a result, a uniform screen mesh cloth was obtained, of which the density unevenness in the warp direction and the weft direction was less than 3 %. The screen mesh cloth was evaluated for the hysteresis, and its C value was 99 % and its dimensional stability was thus good.

**Claims**

1. A polyester monofilament for screen mesh cloth **characterized in that**, after processed with boiling water, its inclination change B/A is from 0.6 to less than 1.0, wherein A indicates the inclination of the elongation-stress curve just before the primary yield point thereof and B indicates the inclination of the elongation-stress curve just after the primary yield point.

2. The monofilament for screen mesh cloth as claimed in claim 1, wherein the monofilament is a core/sheath bicomponent polyester monofilament.

3. The monofilament for screen mesh cloth as claimed in claim 2, wherein the monofilament satisfies the following requirements A to H:

   1) Before wet heat treatment of the monofilament, the maximum point strength of the raw yarn is from 5. 5 to 8.0 cN/dtex, the strength at 5 % elongation thereof is from 3.8 to 5.5 cN/dtex, the maximum point elongation thereof is from 8 to 20 %, and the wet heat shrinkage thereof is from 0.5 to 3.5 %,
   2) After wet heat treatment of the monofilament, the maximum point strength of the raw yarn is from 5.0 to 7.8 cN/dtex, and the maximum point elongation thereof is from 15 to 30 %,
   3) The main ingredient of the polyester of the core is polyethylene naphthalate having an intrinsic viscosity of from 0.50 to 0.80 dL/g,
   4) The polyester of the sheath is polyethylene terephthalate having an intrinsic viscosity of from 0.40 to 0.65 dL/g,
   5) The polyester of the sheath has a birefringence of from $140 \times 10^{-3}$ to $170 \times 10^{-3}$,
   6) The core/sheath area ratio of the cross section perpendicular to the fiber axis is from 30/70 to 90/10,
   7) The monofilament fineness is from 4 to 24 dtex,
   8) The number of knobs having a size of at least 1.1 times relative to the fiber diameter is at most 1, in 500,000 m in the machine direction of the monofilament fiber.

4. A method for producing a screen mesh cloth, comprising processing a fabric formed of the monofilament for screen mesh cloth of claim 1 to 3, with boiling water, then heat-setting it while stretched by from 0.2 to 5 % both in the warp direction and in the weft direction, and further stretching it by from 0.3 to 5 % and fixing it.

<div align="center">

**INTERNATIONAL SEARCH REPORT**

</div>

| | International application No. |
|---|---|
| | PCT/JP2008/059407 |

**A. CLASSIFICATION OF SUBJECT MATTER**
*D01F8/14*(2006.01)i, *B41N1/24*(2006.01)i, *D01F6/62*(2006.01)i, *D03D1/00*(2006.01)i, *D03D9/00*(2006.01)i, *D03D15/00*(2006.01)i, *D03D15/02*(2006.01)i

According to International Patent Classification (IPC) or to both national classification and IPC

**B. FIELDS SEARCHED**

Minimum documentation searched (classification system followed by classification symbols)
D01F8/14, B41N1/24, D01F6/62, D03D1/00, D03D9/00, D03D15/00, D03D15/02

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2-277818 A  (Toray Industries, Inc.), 14 November, 1990 (14.11.90), Page 4, lower left column, line 7 to lower right column, 4th line from the bottom; Fig. 1 (Family: none) | 1 2-4 |
| Y | JP 4-100914 A  (Toray Industries, Inc.), 02 April, 1992 (02.04.92), Page 4, upper right column, line 8 to 3rd line from the bottom (Family: none) | 2-4 |
| Y | JP 2005-248357 A  (Teijin Techno Products Ltd.), 15 September, 2005 (15.09.05), Full text (Family: none) | 2-4 |

☒  Further documents are listed in the continuation of Box C.          ☐  See patent family annex.

| | |
|---|---|
| *    Special categories of cited documents:<br>"A"  document defining the general state of the art which is not considered   to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| 12 August, 2008 (12.08.08) | 26 August, 2008 (26.08.08) |

| Name and mailing address of the ISA/<br>Japanese Patent Office | Authorized officer |
|---|---|
| Facsimile No. | Telephone No. |

Form PCT/ISA/210 (second sheet) (April 2007)

**INTERNATIONAL SEARCH REPORT**

| International application No. |
| --- |
| PCT/JP2008/059407 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | JP 2004-211221 A (Toray Industries, Inc.),<br>29 July, 2004 (29.07.04),<br>Full text<br>(Family: none) | 2-4 |
| P,Y | JP 2008-101287 A (Teijin Fibers Ltd.),<br>01 May, 2008 (01.05.08),<br>Full text<br>(Family: none) | 2-4 |

Form PCT/ISA/210 (continuation of second sheet) (April 2007)

8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2289120 A